# EUROPÄISCHE PATENTSCHRIFT

(11) **EP 1 189 342 B1**
(45) Veröffentlichungstag und Bekanntmachung des Hinweises auf die Patenterteilung: **23.02.2005**
(21) Anmeldenummer: 01118174.0
(22) Anmeldetag: 26.07.2001
(51) Int. Cl.: H03F 3/72, H04N 7/10

(54) **Verstärker, insbesondere Satelliten-Zwischenfrequenz-Verstärker**
Amplifier, especially inter-frequency amplifier for satellites
Amplificateur, en particulier amplificateur d'inter-fréquence pour satellites

(30) Priorität: 10.08.2000 DE 20013821 U
(43) Veröffentlichungstag der Anmeldung: 20.03.2002
(73) Patentinhaber: Kathrein-Werke KG, 83022 Rosenheim (DE)
(72) Erfinder: Linke, Christian, 83404 Ainring (DE); Auer, Michael, 83122 Samerberg (DE); Exler, Ralf, 83059 Kolbermoor (DE); Brandstädter, Rudolf, 83071 Stephanskirchen (DE)
(74) Vertreter: Flach, Dieter Dipl.-Ing

(56) Entgegenhaltungen:
- JP-A- 9 312 539
- JP-A- 63 171 006
- "VERTEILUNG VON SATELLITENPROGRAMMEN" RADIO FERNSEHEN ELEKTRONIK, VEB VERLAG TECHNIK. BERLIN, DE, Bd. 49, Nr. 4, 2000, Seiten 62-63, XP000963677 ISSN: 1436-1574

## Beschreibung

Die Erfindung betrifft einen Verstärker, insbesondere einen SAT-ZF-Verstärker nach dem Oberbegriff des Anspruches 1.

In der Satelliten-Zwischenfrequenz-Verteiltechnik ist es üblich, an den Stammleitungen je nach Bedarf eine oder mehrere Matrix-Schaltungen zuzuschalten. Üblicherweise haben diese Matrix-Schaltungen zumindest fünf Ein- und fünf Ausgänge, nämlich üblicherweise zwei Eingänge, worüber die über die vertikale bzw. horizontale Polarisation von einem höheren Frequenzband ausgestrahlten Programme sowie zwei weitere Eingänge, worüber die über die vertikale bzw. horizontale Polarisation von einem unteren Frequenzband ausgestrahlten Programme empfangen werden können. Über den fünften Eingang werden die von einer terrestrischen Antenne empfangenen Signale weitergeleitet.

Da die so aufgebauten Matrix-Schaltungen zum großen Teil vier Ausgänge für vier anzuschließende Teilnehmer aufweisen, ist es häufig üblich, mehrere derartiger Matrix-Schaltungen zusammenzuschalten. Dadurch wird allerdings das Signal pro verwendeter Matrix-Schaltung gedämpft. Von daher ist es ferner üblich, die am Stamm einer Matrixverteilkaskade auftretende Dämpfung mittels Breitbandverstärker auszugleichen.

In der Regel treten nach Zusammenschaltung von drei Durchgangsumschaltmatrizen Dämpfungen von ca. 6 dB bis 12 dB auf. Von daher ist es üblich, jeweils drei zusammengeschaltete Umschaltmatrizen zusammen mit einem am Ausgang angeschlossenen Verstärker zu sogenannten Modulen zusammenzuschalten, bei denen die Eingangsverhältnisse im Idealfall fast wieder hergestellt werden, also der zugeschaltete ZF-Verstärker die in den Umschaltmatrizen verursachte Dämpfung wieder ausgleicht.

Sind weitere Matrix-Schaltungen notwendig, so könnten diese beispielsweise wieder zu Baugruppen von drei Matrizen mit einem ausgangsseitig zugeschalteten Verstärker hinzugeschaltet werden. Häufig jedoch werden derartige Gruppen von drei Matrizen und einem ZF-Verstärker aber nicht unmittelbar zusammengeschaltet. In vielen Anwendungsfällen werden nämlich vom Verstärker ausgehend zunächst einmal Koaxialkabel in ein nächstes Stockwerk in einem Gebäude verlaufend verlegt, um dort eine oder mehrere Moduleinheiten, bestehend beispielsweise wiederum aus drei Umschaltmatrizen mit einem ausgangsseitigen ZF-Verstärker zuzuschalten. Durch die Koaxialkabel werden aber zusätzliche Dämpfungen verursacht.

Nachteilig ist also bei dieser Konfiguration die hohe Spezialisierung der Verstärker. Denn diese sind mit ihrem Verstärkungswert so eingestellt, dass sie beispielsweise die Dämpfung für die erwähnten drei zusammengeschalteten Umschaltmatrizen ausgleichen. Wenn aber die ausgleichende Verstärkung in dem ZF-Verstärker lediglich darauf abgestimmt ist die auftretende Dämpfung in den Umschaltmatrizen auszugleichen, so steht für die weitere Dämpfung, die beispielsweise durch zugeschaltete Anschlusskabel verursacht wird, keine weitere Verstärkung mehr zur Verfügung. Beim Zusammenschalten mehrerer Module mittels koaxialer Kabelleitungen steigt also die Dämpfung am Stamm weiter an.

Darüber hinaus sind auch andere Problemfälle möglich, wenn nämlich beispielsweise (wenn z.B. gegebenenfalls nur zwei Umschaltmatrizen zusammengeschaltet sind) der den Umschaltmatrizen nachgeschaltete ZF-Verstärker eine zu große Verstärkung aufweist. Dann neigt nämlich das gesamte System bei verlustarmer Zusammenschaltung zur Übersteuerung.

Von daher ist es bereits bekannt, zum Ausgleich dieser Unterschiede Verstärker vorzusehen, die integrierte Dämpfungs-Einstellglieder aufweisen. Dies hat jedoch den Nachteil, dass jeder Verstärker nach der Montage separat eingepegelt werden muss.

Eine gattungsbildende Verstärkerschaltung ist aus der JP-A-63 171 006 bekannt geworden. Diese Verstärkerschaltung umfasst zwischen einem Eingang und einem Ausgang zwei parallel geschaltete Zweige, worüber ein erster und ein zweiter Signalweg definiert sind. Zwischen diesen beiden Signalwegen kann umgeschaltet werden, so dass jeweils nur der in dem einen Zweig vorgesehene Verstärker aktiv und der in dem anderen Zweig vorgesehene Verstärker abgeschaltet ist. Die Umschaltung zwischen beiden Signalwegen erfolgt mittels eines externen Schalters, der von einer Kippstellung in eine andere Kippstellung umgeschaltet werden kann. Während der Verstärkungsfaktor in einem Signalweg konstant ist, kann der Verstärkungsfaktor in dem anderen Signalweg mittels einer Einstelleinrichtung variabel eingestellt werden.

Eine insoweit vergleichbare Schaltungsanordnung, bei der mittels eines Schalters von einem Signalweg auf den anderen Signalweg umgeschaltet werden kann, ist grundsätzlich auch aus der JP-A-09 312 539 bekannt geworden.

Aufgabe der Erfindung ist es von daher, ausgehend von dem gattungsbildenden Stand der Technik, einen verbesserten Verstärker zu schaffen, der möglichst einfach aufgebaut und vor allem eine einfache Umschaltung von einem Betriebsmodus mit einem bestimmten Verstärkungsfaktor in einen zweiten Betriebsmodus mit einem einstellbar veränderbaren Verstärkungsfaktor bietet.

Die Aufgabe wird erfindungsgemäß entsprechend den im Anspruch 1 angegebenen Merkmalen gelöst. Vorteilhafte Ausgestaltungen der Erfindung sind in den Unteransprüchen angegeben.

Bei dem erfindungsgemäßen Verstärker werden die geschilderten Nachteile vermieden.

Die vorliegende Erfindung zeichnet sich durch eine besonders ausgestaltete und geeignete Umschalteinrichtung aus. Im Gegensatz zu einem Schalter, wie er im Stand der Technik vorgesehen ist, der von einer Schaltstellung in die andere Schaltstellung direkt umgeschaltet werden muss, wodurch unterschiedliche Schaltsignale entsprechend dem durch die Umschaltung geänderten Signalweg der Verstärkerschaltung zugeführt werden, ist erfindungsgemäß lediglich ein Abschlusswiderstand vorgesehen. Derartige Abschlusswiderstände sind beispielsweise bei koaxialen Antennenleitungen vorgesehen, um eine offene Koaxialleitung entsprechend am Ende abzuschließen. Bevorzugt ist beispielsweise bei abgezogenem oder abgeschraubtem Abschlusswiderstand nur der fest voreingestellte Verstärkungsfaktor wirksam (beispielsweise bei zusammengeschalteten Umschaltmatrizen), wohingegen bei aufgestecktem oder dem aufgeschraubtem Abschlusswiderstand der Verstärkungsfaktor individuell einstell- oder veränderbar ist. Der Abschlusswiderstand kann dabei geeignete Werte aufweisen, vorzugsweise 75 Ohm.

In einer bevorzugten Ausführungsform der Erfindung ist vorgesehen, dass in Abweichung zum Stand der Technik nicht zwei getrennte Signalwege (mittels zweier paralleler Zweigleitungen) vorgesehen sind, um einem zwischen einem fest eingestellten und einem anderen variabel veränderbaren Verstärkungsfaktor zu unterscheiden, sondern es ist lediglich ein einziger Signalweg vorgesehen, in welchem ein veränderbares Regel- oder Pegelglied (Dämpfungsglied) vorgesehen ist. Je nach Zuschaltung des Abschlusswiderstandes wird die Regel- oder Pegelstufe auf einen entsprechend fest vorgegebenen Verstärkungsfaktor oder einen anderen Verstärkungsfaktor umgeschaltet, der zudem noch variabel veränderbar ist.

Werden also in einem Leitungsstamm zusätzliche Koaxialleitungen verwendet, die zu einer zusätzlichen Dämpfung beitragen, und/oder werden beispielsweise nur zwei Umschaltmatrizen oder vielleicht sogar vier Umschaltmatrizen unmittelbar hintereinander geschaltet, so dass eine zu geringe oder zu starke Dämpfung bezogen auf den voreingestellten Verstärkungsfaktor des ZF-Verstärkers gegeben ist, so kann nunmehr durch Umschalten in einen zweiten Betriebsmodus eine an sich vorgesehene Einstelleinrichtung zur Veränderung des Verstärkungsfaktors aktiviert werden. In üblicher Weise kann nunmehr durch Einstellung des Verstärkungsfaktors die gewünschte optimale Verstärkung vorgenommen werden.

Bevorzugt ist vorgesehen, dass nach Umschaltung in den zweiten Betriebsmodus (durch Anschluss des Abschlusswiderstandes an einem koaxialen Schaltanschluss) der Verstärkungsfaktor um einen fest voreingestellten Wert ansteigt, beispielsweise um 6 dB im SAT-Bereich und um beispielsweise 4 dB im terrestrischen Bereich.

Schließlich kann durch die Einstellglieder für den terrestrischen Übertragungsbereich die über das zumindest eine Einstellglied im SAT-Übertragungsbereich der Verstärkungsfaktor noch weiter angehoben oder sogar über den üblichen Ausgangswert nach unten hin abgesenkt werden. Bevorzugt wird zur Veränderung des Verstärkungsfaktors in der SAT-Übertragungsgegend eine an sich bekannte Synchronregelung verwendet.

Die Erfindung wird nachfolgend anhand von Ausführungsbeispielen näher erläutert. Dabei zeigen im einzelnen:
- Figur 1 :: in schematischer Form eine Stamm-Übertragungsstrecke mit jeweils zwei Modulgruppen bestehend aus drei Umschaltmatrizen mit nachgeschaltetem erfindungsgemäßen ZF-Verstärker; und
- Figur 2 :: ein schematischer ausschnittsweiser Schaltplan zur Verdeutlichung der Funktionsweise des ZF-Verstärkers.

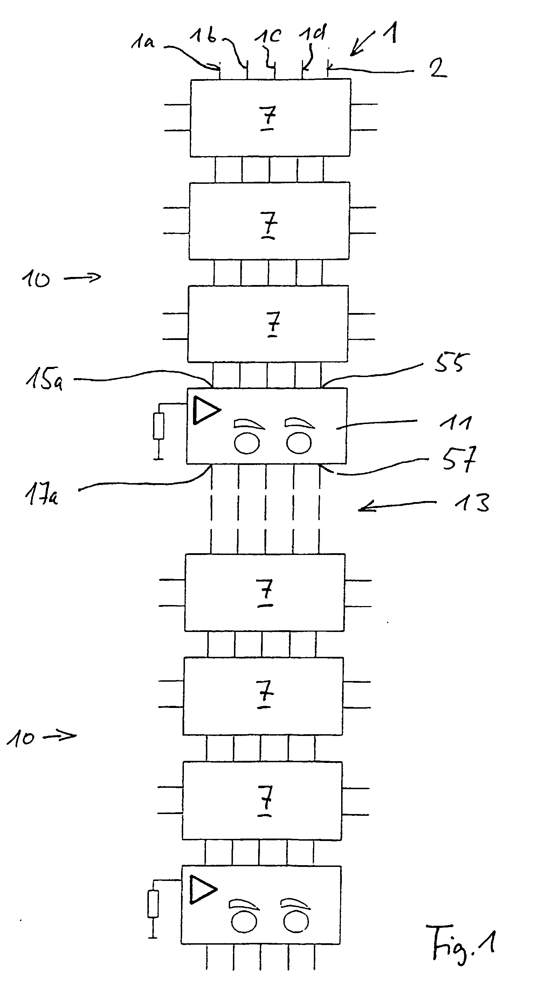

In Figur 1 ist schematisch eine Stammstrecke 1 gezeigt, über welche die Programme von einer Satelliten-Empfangsanlage oder einer Kopfstelle an eine Vielzahl von angeschlossenen Teilnehmern weitergeleitet werden.

Obgleich es nicht zwingend notwendig ist, umfasst eine derartige Stammstrecke üblicherweise fünf Leitungen, nämlich 2 x 2 Leitungen 1a bis 1d, wobei beispielsweise über die Leitungen 1a und 1b die über eine vertikale wie horizontale Polarisation in einem oberen Frequenzband empfangenen Programme und über zwei weitere Leitungen 1c und 1d die über eine vertikale wie horizontale Polarisation in einem unteren Frequenzband empfangenen Programme zu den Teilnehmern übertragen werden. Über die fünfte Leitung 2 werden die von einer terrestrischen Antenne empfangenen Programme an die Teilnehmer weitergeleitet.

Um möglichst viele Teilnehmer an den Teilnehmeranschlüssen 5 zuschalten zu können, werden sogenannte Umschalt- und/oder Verteilmatrizen 7 verwendet, die kaskadiert zusammengeschaltet werden können.

In einem Gebäude erfolgt dabei häufig die Verteilung pro Stockwerk, wobei die Stammstrecke 1 beispielsweise zu einem ersten Modul 10 bestehend aus drei Umschaltmatrizen und einem ausgangsseitig zugeschalteten ZF-Verstärker 11 besteht. Über nachfolgende Koaxialleitungen 13 erfolgt die Verbindung zu einem nächsten Stockwerk, wo beispielsweise wieder ein Modul oder zwei Module 10 aus jeweils drei Umschaltmatrizen mit ausgangsseitig nachgeschaltetem ZF-Verstärker 11 vorgesehen sind usw.

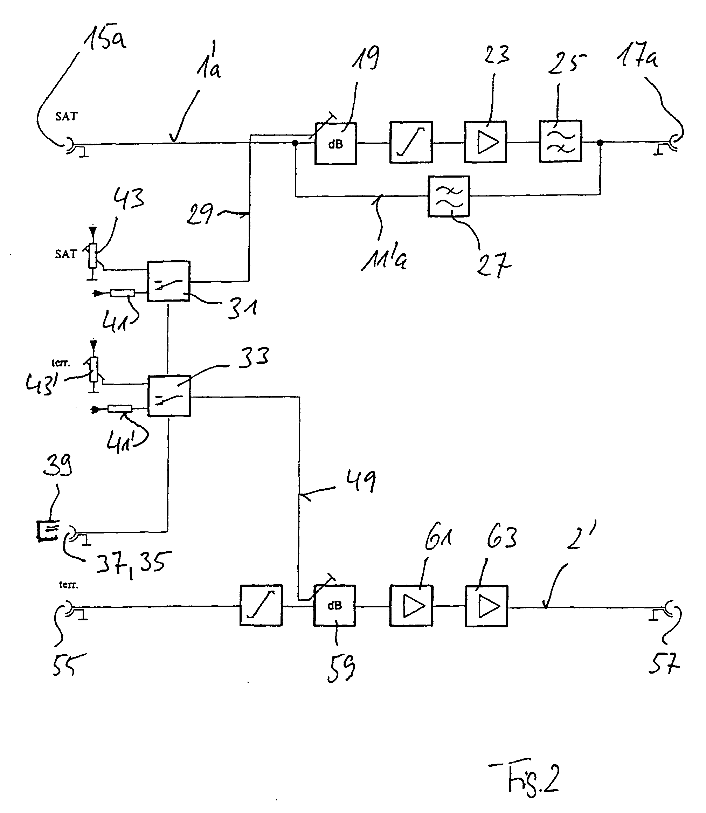

Anhand von Figur 2 ist nunmehr der Aufbau eines derartigen ZF-Verstärkers 11 im größeren Detail gezeigt, wobei die mit der Stammleitung 2 in Verbindung stehende innere Stammstrecke 2' zur Übertragung der terrestrischen Signale dargestellt ist, und von den im Ausführungsbeispiel gemäß Figur 1 vorgesehenen vier Stammstrecken 1a bis 1d zur Übertragung der über die vertikalen und horizontalen Polarisationen in einem oberen und unteren Frequenzband empfangenen Programme nur eine Stammstrecke 1'a im Verstärker 11 stellvertretend gezeigt ist. Die Schaltung gilt insoweit für die anderen Leitungen 1'b bis 1'd entsprechend.

Zwischen einem Eingang 15a und einem Ausgang 17a (und analog für die Eingänge 15b bis 15d bzw. die Ausgänge 17b - 17d entsprechend, ohne dass dies in Figur 2 gezeigt ist) ist ein einstellbares Regel- oder Pegelglied 19 zur veränderlichen Einstellung des Verstärkungsfaktors vorgesehen, sowie eine Verstärkerstufe 23 und ein nachgeschaltetes Filter 25 (Hochpassfilter). Über eine diese Baugruppen überbrückenden Parallelleitung 11'a ist eine hochfrequenztaugliche Gleichspannungsumgebung 27 geschaltet.

Zur Veränderung des Verstärkungsfaktors ist das einstellbare Regel- oder Pegelglied 19 über eine Einstellleitung 29 mit einer Umschaltstufe 31 verbunden. Diese Umschaltstufe 31 kann zur Einstellung aller Regel- oder Pegelglieder 19 für alle vier SAT-Übertragungsstrecken 1'a bis 1'd dienen, oder aber es sind vier derartige Regel- oder Pegelglieder 19 parallel geschaltet.

Darüber hinaus wird eine weitere Umschaltstufe 33 zur Einstellung des Verstärkungsfaktors im terrestrischen Zweig 2 vorgesehen.

Beide Umschaltstufen 31 und 33 sind über eine Auslöseleitung 35 mit einem Anschluss 37 verbunden, an welchem ein in Figur 2 nur angedeuteter Abschlusswiderstand 39 anschließbar ist, beispielsweise durch Aufstecken oder in Form eines schraubbaren Abschlusswiderstandes.

Wie aus Figur 2 auch zu ersehen ist, sind die beiden Umschaltstufen jeweils mit zwei weiteren Eingängen versehen, an denen einmal ein Festwiderstand 41 bzw. 41' und ein regelbarer Widerstand 43 bzw. 43' zugeschaltet ist.

Nachfolgend wird auf die Funktionsweise eingegangen.

Wird an dem Anschluss 37 kein Abschlusswiderstand 39 angeschlossen, ist also der Anschluss 37 unbeschaltet, so sind die beiden Umschaltstufen 31 und 33 in die in Figur 2 gezeigte Stellung umgeschaltet, bei der der regelbare Widerstand 43 bzw. 43' unwirksam ist. Da somit nur der Festwiderstand 41 bzw. 41' wirksam ist, ist dadurch die einstellbare Regel- bzw. Pegelstufe 19 nur auf einen entsprechend fest vorgegebenen Verstärkungsfaktor eingestellt. Diese Schaltstellung entspricht dem einen üblichen Betriebsmodus, der so eingestellt ist, dass er eine Dämpfung beispielsweise bezüglich dreier zusammengeschalteter Umschaltmatrizen 7 mit einer Gesamtdämpfung von ca. 9 dB ausgleichen kann, also im Idealfall wieder die Eingangsverhältnisse vor den drei Umschaltmatrizen herstellt.

Verlangen es nunmehr die Einsatzfälle, dass beispielsweise aufgrund noch vorhandener verlegter Anschlusskabel die Dämpfung insgesamt höher ist und somit eine höhere Verstärkung zum Ausgleich davon verlangt wird oder dass beispielsweise nur zwei Umschaltmatrizen oder weniger vorgesehen sind, und somit der Verstärkungsfaktor niedriger eingestellt werden müsste, so kann am Anschluss 37 der erwähnte Abschlusswiderstand 39 zugeschaltet werden. Dadurch schalten die Umschaltstufen 31 und 33 automatisch in ihre zweite Schaltstellung um, bei der nunmehr nicht der Festwiderstand 41, 41', sondern der regelbare Widerstand 43, 43' (Potentionmeter) wirksam ist. Die Ausgangswirkung ist dabei wiederum so fertigungstechnisch voreingestellt, dass bestimmte höhere Verstärkungswerte voreingestellt sind, beispielsweise eine um 6 dB höhere Verstärkung für die SAT-Übertragungswege und eine um 4 dB höhere Verstärkung auf dem terrestrischen Übertragungsweg.

Davon abweichend kann nunmehr durch individuelle Verstellung der regelbaren Widerstände 43 (Potentiometer) synchron über die Einstellleitungen 29 die entsprechenden Regel- oder Pegelglieder 19 angesteuert und damit der Verstärkungsfaktor für alle vier SAT-Übertragungswege gemeinsam und gleichzeitig verändert werden. Über den zweiten regelbaren Widerstand 43' kann davon getrennt der Verstärkungsfaktor für den terrestrischen Übertragungsweg eingestellt werden. Dabei ist aus Figur 2 auch zu ersehen, dass über den Widerstand 43' und die nachfolgende Umschaltstufe 33 über die nachgeordnete Einstellleitung 49 in der betreffenden Regel- und Pegelstufe 59 der entsprechende Verstärkungsfaktor für den terrestrischen Übertragungsweg 2' eingestellt werden. Im gezeigten Ausführungsbeispiel weist dabei der interne Übertragungsweg 2' für den terrestrischen Übertragungsweg in der Regel- und Pegelstufe 19 beispielsweise zwei Verstärkerstufen 61 und 63 auf, wobei dieser interne terrestrische Verstärkungsweg 2' zwischen dem zugehörigen Eingang 55 und dem Ausgang 57 geschaltet ist.

Bei Bedarf kann hierüber aber auch der Verstärkungsfaktor unter dem im Betriebsmodus 1 vorgesehenen Verstärkungsfaktor hinaus nach unten gesenkt werden.

Die Gleichspannung kann dabei bei allen SAT-Zweigen durchgespeist werden.

Nur zur Vervollständigung der Darstellung gemäß Figur 2 wird angemerkt, dass in der Stammstrecke 1'a (und entsprechend in den weiteren nicht gezeigten Stammstrecken im Verstärker) zwischen den Regel und/oder Pegelgliedern 19 und dem Verstärker 23 noch ein Leitungsentzerrer vorgesehen ist, ähnlich wie in dem terrestrischen Zweig 2' vor dem dortigen Regel- oder Pegelglied 59.

## Patentansprüche

1. Verstärker, insbesondere SAT-ZF-Verstärker mit folgenden Merkmalen:
- der Verstärker (11) umfasst zumindest zwei Betriebsarten,
- in einem ersten Betriebsmodus ist ein bestimmter Verstärkungsfaktor vorgegeben,
- in einem zweiten Betriebsmodus ist der Verstärkungsfaktor mittels einer Einstelleinrichtung (43, 43') veränderlich einstellbar, und
- zwischen den beiden Betriebsarten kann mittels einer Umschalteinrichtung umgeschaltet werden,
**gekennzeichnet durch** die folgenden weiteren Merkmale:
- die Umschalteinrichtung umfaßt einem zuschalt- bzw. anschließbaren Abschlusswiderstand (39) in dessen Abhängigkeit die Umschaltung zwischen den Betriebsarten erfolgt.

2. Verstärker nach Anspruch 1, **dadurch gekennzeichnet, dass** in dem ersten Betriebsmodus der vorgegebene Verstärkungsfaktor nicht veränderbar ist.

3. Verstärker nach Anspruch 1 oder 2, **dadurch gekennzeichnet, dass** bei Umschaltung in den zweiten Betriebsmodus mit veränderlich einstellbarem Verstärkungsfaktor ein bestimmter Verstärkungsfaktor werkseitig vorgegeben ist.

4. Verstärker nach Anspruch 3, **dadurch gekennzeichnet, dass** der Verstärker ein SAT-ZF-Verstärker mit einem SAT-Übertragungsweg und einem Übertragungsweg für terrestrisch empfangene Programme ist und **dass** bei Umschaltung in den Betriebsmodus mit veränderlich einstellbarem Verstärkungsfaktor der Verstärkungsfaktor in dem SAT-Übertragungsweg (1'a bis 1'd) unterschiedlich vorgegeben ist zu dem veränderlich einstellbaren Verstärkungsfaktor in dem Übertragungsweg (2) für die terrestrisch empfangenen Programme.

5. Verstärker nach einem der Ansprüche 1 bis 4, **dadurch gekennzeichnet, dass** der Verstärkungsfaktor in dem ersten Betriebsmodus so vorgewählt ist, dass er zum Ausgleich der Dämpfung einer vorgegebenen Anzahl von zusammengeschalteten Umschaltmatrizen (7) angepasst ist, vorzugsweise auf die Dämpfung, die von drei zusammengeschalteten Umschaltmatrizen (7) bewirkt wird.

6. Verstärker nach einem der Ansprüche 1 bis 3, **dadurch gekennzeichnet, dass** der Verstärker ein SAT-ZF-Verstärker mit einem SAT-Übertragungsweg und einem Übertragungsweg für terrestrisch empfangene Programme ist und **dass** zumindest eine Umschaltstufe (31) für die satellitempfangenen Programme und vorzugsweise eine Umschaltgruppe (33) für den terrestrischen Zweig (2') zur Umschaltung zwischen den beiden Betriebsarten vorgesehen ist.

7. Verstärker nach Anspruch 6, **dadurch gekennzeichnet, dass** die Umschaltstufe (31, 33) bei nicht angeschlossenem Abschlusswiderstand (39) sich in einer ersten Schaltstellung befindet und **dadurch** der Verstärkungsfaktor durch einen eingangsseitig vorgeschalteten Widerstand (41, 41') festgelegt ist, und dass bei angeschlossenem Abschlusswiderstand (39) die Umschaltstufe (31, 33) in ihre zweite Betriebsstufe umgeschaltet ist und **dadurch** der Verstärkungsfaktor über einen, an einem anderen Eingang angeschlossenen regelbaren Widerstand (43, 43') bestimmt wird.

8. Verstärker nach Anspruch 7, **dadurch gekennzeichnet, dass** durch den regelbaren Widerstand (43, 43') eine in der jeweiligen Verstärkerstrecke (1'a bis 1'd, 2') geschaltete Regel- oder Pegelglied (19, 49) zur Veränderung des Verstärkungsfaktors ansteuerbar ist.

## Claims

1. Amplifier, in particular an SAT-IF amplifier, having the following features:
- the amplifier (11) has at least two operating modes,
- in a first operating mode, a specific gain factor is predetermined,
- in a second operating mode, the gain factor can be varied by means of an adjustment device (43, 43'), and
- a switching device can be used to switch between the two operating modes,
**characterized by** the following further features:
- the switching device has a terminating resistor (39) which can be connected or switched on and as a function of which switching between the operating modes takes place.

2. Amplifier according to Claim 1, **characterized in that** the predetermined gain factor cannot be varied in the first operating mode.

3. Amplifier according to Claim 1 or 2, **characterized in that**, when switching to the second operating mode with a variable gain factor, a specific gain factor is preset at the factory.

4. Amplifier according to Claim 3, **characterized in that** the amplifier is an SAT-IF amplifier with an SAT transmission path and a transmission path for terrestrially received programs, and **in that**, when switching to the operating mode with a variable gain factor, the gain factor is preset differently in the SAT transmission path (1'a to 1'd) to the variable gain factor in the transmission path (2) for the terrestrially received programmes.

5. Amplifier according to one of Claims 1 to 4, **characterized in that** the gain factor in the first operating mode is preset such that it is adapted in order to compensate for the attenuation of a predetermined number of interconnected switching matrices (7), preferably to the attenuation which is produced by three interconnected switching matrices (7).

6. Amplifier according to one of Claims 1 to 3, **characterized in that** the amplifier is an SAT-IF amplifier with an SAT transmission path and a transmission path for terrestrially received programmes, and **in that** at least one switching stage (31) is provided for programmes received from satellites, and a switching group (33) is preferably provided for the terrestrial branch (2'), in order to switch between the two operating modes.

7. Amplifier according to Claim 6, **characterized in that** the switching stage (31, 33) when the terminating resistor (39) is not connected is located in a first switch position and, in consequence, the gain factor is defined by a resistor (41, 41') connected upstream on the input side, and **in that**, when the terminating resistor (39) is connected, the switching stage (31, 33) is switched to its second operating stage and, in consequence, the gain factor is determined via a controllable resistor (43, 43') which is connected to another input.

8. Amplifier according to Claim 7, **characterized in that** a regulating or level element (19, 49) which is connected in the respective amplifier branch (1'a to 1'd, 2') can be driven by the controllable resistor (43, 43') in order to vary the gain factor.

## Revendications

1. Amplificateur, en particulier amplificateur à fréquence intermédiaire pour satellite, présentant les éléments suivants :
-- l'amplificateur (11) présente au moins deux modes de fonctionnement,
-- dans un premier mode de fonctionnement est imposé un facteur d'amplification déterminé,
-- dans un second mode de fonctionnement, le facteur d'amplification est réglable de façon variable au moyen d'un dispositif de réglage (43, 43'), et
-- il est possible de commuter entre les deux modes de fonctionnement au moyen d'un dispositif de commutation,
**caractérisé par** les caractéristiques suivantes :
-- le dispositif de commutation comprend une résistance de terminaison (39) susceptible d'être branchée ou raccordée, la commutation entre les modes de fonctionnement ayant lieu en dépendance de cette résistance de terminaison.

2. Amplificateur selon la revendication 1, **caractérisé en ce que** dans le premier mode de fonctionnement, le facteur d'amplification imposé n'est pas modifiable.

3. Amplificateur selon l'une ou l'autre des revendications 1 et 2, **caractérisé en ce que** lors de la commutation dans le second mode de fonctionnement avec facteur d'amplification réglable de façon variable, un facteur d'amplification déterminé est imposé en usine.

4. Amplificateur selon la revendication 3, **caractérisé en ce que** l'amplificateur est un amplificateur à fréquence intermédiaire pour satellite avec une voie de transmission pour des programmes reçus d'un satellite et une voie de transmission pour des programmes reçus par voie terrestre, et **en ce que** lors de la commutation dans le mode de fonctionnement avec facteur d'amplification réglable de façon variable, le facteur d'amplification dans la voie de transmission pour satellite (1'a à 1'd) est imposé de façon différente au facteur d'amplification réglable de façon variable dans la voie de transmission (2) pour les programmes reçus par voie terrestre.

5. Amplificateur selon l'une des revendications 1 à 4, **caractérisé en ce que** le facteur d'amplification dans le premier mode de fonctionnement est présélectionné de manière à ce qu'il soit ajusté pour compenser l'amortissement d'un nombre prédéterminé de matrices de commutation (7) interconnectées, de préférence l'amortissement qui est assuré par trois matrices de commutation (7) interconnectées.

6. Amplificateur selon l'une des revendications 1 à 3, **caractérisé en ce que** l'amplificateur est un amplificateur à fréquence intermédiaire pour satellite avec une voie de transmission pour des programmes reçus d'un satellite et une voie de transmission pour des programmes reçus par voie terrestre, et **en ce qu'**il est prévu au moins un étage de commutation (31) pour les programmes reçus d'un satellite et de préférence un groupe de commutation (33) pour la branche terrestre (2') pour la commutation entre les deux modes de fonctionnement.

7. Amplificateur selon la revendication 6, **caractérisé en ce que** l'étage de commutation (31, 33), lorsque la résistance de terminaison (39) n'est pas raccordée, se trouve dans une première position de commutation, et de ce fait le facteur d'amplification est fixé par une résistance (41, 41') branchée en amont du côté entrée, et **en ce que** lorsque la résistance de terminaison (39) est raccordée, l'étage de commutation (31, 33) est commuté vers son deuxième étage de fonctionnement, et de ce fait le facteur d'amplification est déterminé par une résistance réglable (43, 43') raccordée à une autre entrée.

8. Amplificateur selon la revendication 7, **caractérisé en ce que**, au moyen de la résistance réglable (43, 43'), un circuit de régulation ou de niveau (19, 49) branché dans la voie d'amplification respective (1'a à 1'd, 2') est pilotable au moyen de la résistance réglable (43, 43') pour modifier le facteur d'amplification.
